(19) Europäisches Patentamt
European Patent Office
Office européen des brevets

(11) EP 1 742 514 A1

(12) # EUROPEAN PATENT APPLICATION
published in accordance with Art. 158(3) EPC

(43) Date of publication:
**10.01.2007 Bulletin 2007/02**

(21) Application number: **04724733.3**

(22) Date of filing: **31.03.2004**

(51) Int Cl.:
***H05B 33/14*** *(2006.01)*

(86) International application number:
**PCT/JP2004/004579**

(87) International publication number:
**WO 2005/104626 (03.11.2005 Gazette 2005/44)**

(84) Designated Contracting States:
**AT BE BG CH CY CZ DE DK EE ES FI FR GB GR HU IE IT LI LU MC NL PL PT RO SE SI SK TR**

(71) Applicant: **Fujitsu Ltd.**
**Kawasaki-shi, Kanagawa 211-8588 (JP)**

(72) Inventors:
- **SATOH, Tasuku,**
  **c/o Fuji Photo Film Co,Ltd**
  **Ashigarakami-gun Kanagawa (JP)**
- **SAKAMOTO, Yoshiaki,**
  **Fuji Photo Film Co,Ltd**
  **Ashigarakami-gun Kanagawa (JP)**
- **TAKAHASHI, Toshirou,**
  **c/o Fuji Photo Film Co,Ltd**
  **Ashigarakami-gun Kanagawa (JP)**

(74) Representative: **HOFFMANN EITLE**
**Arabellastrasse 4**
**81925 München (DE)**

(54) **PASSIVE MATRIX LIGHT EMITTING DEVICE**

(57) A light emitting device, including a substrate, and multiple drive electrodes formed on the substrate and used to obtain desired light emission, the multiple drive electrode forming a passive-matrix-driven electrode arrangement, wherein at least one drive electrode in a display region of the substrate forms an angle, that is neither parallel nor perpendicular to a given side of the display region.

FIG.2

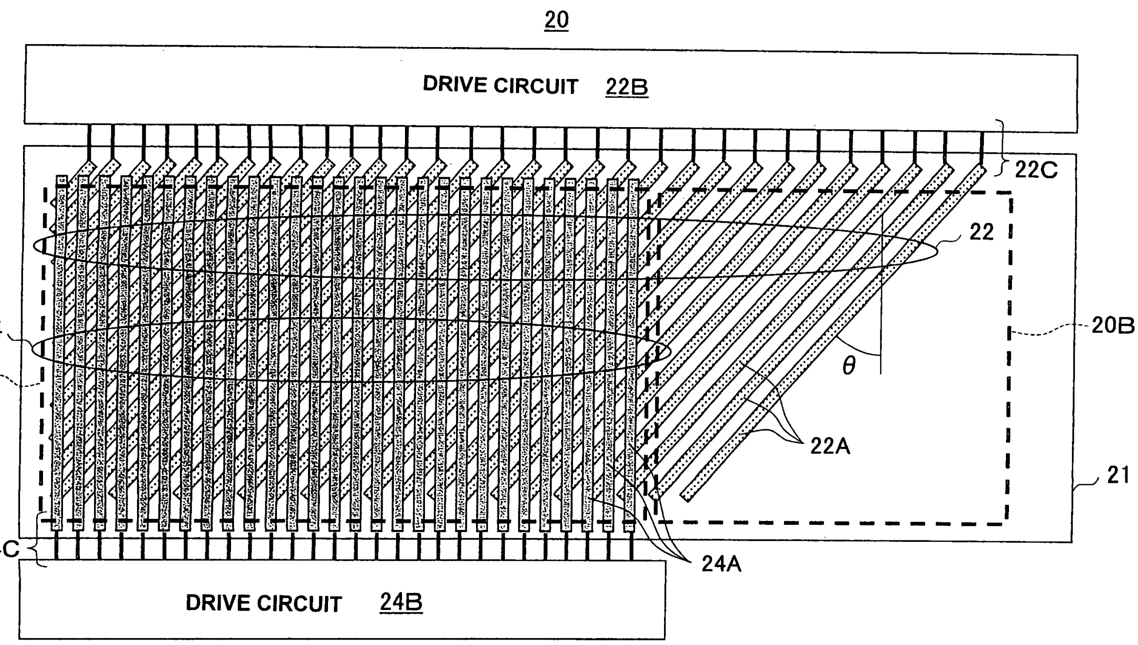


EP 1 742 514 A1

## Description

TECHNICAL FIELD

The present invention relates generally to display devices, and specifically the invention relates to light emitting devices including passive-matrix display devices.

BACKGROUND ART

Voltage-driven liquid crystal display devices are used widely as display devices.

Liquid crystal display devices are used for providing large amounts of visual information such as motions picture at high speed and generally are operated in the so-called active matrix mode wherein each pixel is driven by a single thin-film transistor.

In addition to liquid crystal display devices, which display information by spatial modulation of light from a light source device such as a backlight, self-luminous display devices such as plasma display device have commercialized recently. In self-luminous display devices, problems related to viewing angles, which can be seen in liquid crystal display devices, do not occur.

In particular, display devices using an organic EL element, which use no liquid or gas as the display medium, are simpler in configuration, robust, and also have the potential for enabling formation of flexible display devices, have been studied intensively. Possible applications thereof include not only information display devices but surface-luminescent light source devices.

Patent Document 1: Japanese Patent Application Laid-Open (JP-A) No. 03-214593
Patent Document 2: JP-A No. 07-220871
Patent Document 3: JP-A No. 03-152897

DISCLOSURE OF INVENTION

It is preferable to employ a passive matrix configuration containing no thin-film transistor in forming a display device at low cost by using a selfluminous element such as organic EL element, or by using a space-modulation element such as liquid crystal display element. Display devices having an aspect ratio of 3:4 have been generally used for information display, but there exists a need for a display device or a surface light source that is not restricted by the particular aspect ratio.

Fig. 1 is a top view illustrating a display device in a conventional passive-matrix configuration.

As shown in Fig. 1, scanning electrodes 12A of a transparent electrode material such as ITO extending in the crosswise direction are formed repeatedly in the lengthwise direction on a transparent substrate 11, for example, of a glass substrate, and also, data electrodes 14A, for example, of A1 extending in the lengthwise direction are formed repeatedly on the scanning electrodes 12 in the crosswise direction. In addition, organic EL elements (not shown in the Figure) are formed at the intersections of respective scanning electrodes 12A and data electrodes 14A.

When a scanning electrode 12A and one or more data electrodes 14A are selected and drive current flows from the scanning electrode 12A to the multiple data electrodes 14A, the one or more organic EL elements formed on these intersections emit light.

In such a display device, when the aspect ratio of the screen is altered, for example when the length of the crosswise direction is increased for production of a flat slender display device or surface light source, the length of the scanning electrode of ITO 12A increases, causing voltage drop by associated increase in resistivity and consequently, troubles such as deterioration in brightness or complete elimination of light emission by the organic EL element in particular in the area close to the distal end from the drive circuit.

Under the circumstances above, in conventional passive-matrix display devices in which the size or aspect ratio of the screen is restricted, it was difficult to form a display device or light source device, for example, wider in width. In addition, it was necessary to form drive circuits both on the long and short sides in the display region and thus difficult to produce a seamless circular display screen or light-emitting face, on conventional display devices including passive- and active-matrix display devices.

A first aspect of the invention provides a light emitting device including a substrate, and multiple drive electrodes formed on the substrate and used to obtain desired light emission, the multiple drive electrodes forming a passive-matrix-driven electrode arrangement, wherein at least one drive electrode in a display region of the substrates forms an angle, that is neither parallel nor perpendicular to a given side of the display region.

According to the invention, because the drive electrode forms an angle, that is neither parallel nor perpendicular to a given side of the display region, even if the substrate is wider horizontally, it is not needed to extend each of the

scanning line in the multiple drive electrodes from one end to the other in the long side direction of the display region and thus, it is possible to reduce the voltage drop along the scanning line and alleviate deterioration in light intensity of the light-emitting element. It is thus possible to produce a passive-matrix light emitting device at any aspect ratio. Such a display device may be used not only as an information display device but also as a surface light source.

Other characteristics and advantages of the invention will be revealed in the detailed description below with reference to drawings.

BRIEF DESCRIPTION OF DRAWINGS

Fig. 1 is a view illustrating the configuration of a conventional passive-matrix display device.
Fig. 2 is a view illustrating the configuration of a passive-matrix organic EL display device in the first embodiment of the invention.
Fig. 3 is a view illustrating the cross section of the device shown in Fig. 2.
Fig. 4 is a chart showing the emission characteristics of the device shown in Fig. 2.
Fig. 5 is a chart showing the emission characteristic of the passive-matrix display device in a comparative example.
Fig. 6 is a view illustrating the configuration of a modification of the device shown in Fig. 2.
Fig. 7 is a schematic view illustrating a passive-matrix display device in the second embodiment of the invention.
Fig. 8 is a view illustrating the configuration of a modification of the device shown in Fig. 7.
Fig. 9 is a view illustrating the configuration of a passive-matrix display device in the third embodiment of the invention.
Fig. 10 is a view illustrating the device shown in Fig. 9 in detail.
Fig. 11 is a chart showing the emission characteristics of the device shown in Fig. 9.
Fig. 12 is a view of illustrating a part of the passive-matrix display device in a comparative example.
Fig. 13 is a chart showing the mission characteristics of the device shown in Fig. 12.
Fig. 14 is a view of a pixel in the device shown in Fig. 9.
Fig. 15 is a table summarizing the various sized of the pixel in the device shown in Fig. 9.
Fig. 16 is a view illustrating the method of driving a passive-matrix display device in the fourth embodiment of the invention.

BEST MODE FOR CARRYING OUT THE INVENTION

[First embodiment]

Fig. 2 is a top view illustrating the configuration of the passive-matrix plane light emitting device 20 in the first embodiment of the present invention, and Fig. 3 is a sectional view illustrating the passive-matrix plane light emitting device 20 in Fig. 2.

Referring to Fig. 2, the passive-matrix plane light emitting device 20 is formed on a transparent substrate 21 of a plastic such as polycarbonate having an external dimension of 50 mm×119 mm×0.3 mm (aspect ratio: 1:2.2); transparent electrode patterns 22A of ITO having a width of 200 μm and a thickness, for example, of 150 nm are placed as scanning electrodes in parallel with each other at an interval of approximately 10 μm at an angle of 45 degrees with respect to the long and short sides of the substrate 21 is formed on the transparent substrate 21; and thus, the transparent electrode patterns 22A form scanning electrodes 22.

In addition, metal electrode patterns 24A, for example, of Al extending in the short-side direction of the substrate 21 are formed as data electrodes 24 in parallel with each other on the scanning electrodes 22.

In addition, as shown in Fig. 3, an organic EL light-emitting element 23 having a laminated layer configuration of a hole-transporting layer 23a, a light-emitting layer 23b, and an electron-transporting layer 23c is formed, at each intersection of the scanning electrode pattern 22A and data electrode pattern 24A in the display region 20A indicated by a broken line in Fig. 2. Fig. 3 is a sectional view illustrating the passive-matrix plane light emitting device in Fig. 2, as seen along the scanning electrode pattern 22A.

Referring to Fig. 3, a film of α-NPD represented by the following Formula typically having a thickness for example of 50 nm formed by vacuum deposition is used as the hole-transporting layer 23a, and a film ofAlq3 represented by the following Formula typically having a thickness for example of 50 nm formed by vacuum deposition is used as the layer functioning both as a light-emitting layer 23b and an electron-transporting layer 23c.

α-NPD

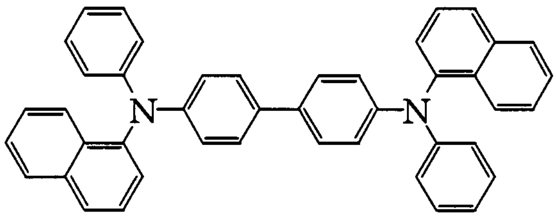

Alq3

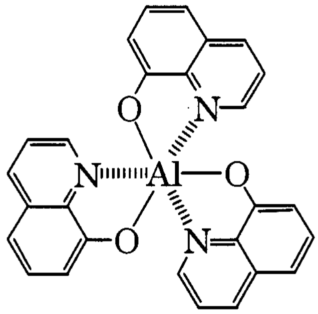

Further, a very thin LiF film (about 0.5 nm, not shown in the Figure) is formed between the electron-transporting layer 23c and the Al electrode 24A for adjustment of work function.

In such an organic EL display device 20 in the passive matrix structure, the first drive circuit 22B is formed along one long side of the substrate 21, and the drive circuit 22B is connected to each of the scanning electrode patterns 22A via a TAB lead 22C. A second drive circuit 24B is formed along the opposite long side of substrate 21 and the drive circuit 24B is connected to each data electrode patterns 24A with a TAB lead 24C.

The drive circuit 22B selects one of the scanning electrode patterns 22A and supplies drive current thereto. The drive circuit 24B selects one or more data electrode patterns 24A in the data electrodes 24, and, as a result, drive current flows from the selected scanning electrode patterns 22A via the organic EL element 23 thereon to the selected data electrode patterns 24A. In this way, the organic EL elements 23 at the intersections between the selected scanning electrode pattern 22A and selected data electrode patterns 24A emit light. When all scanning electrode patterns 22A and all data electrode patterns 24A are selected, all organic EL elements emit light, and the display device of Fig. 2 becomes a surface light source.

In the configuration of Fig. 2, a SiN film (not shown in the Figure) is formed on the non-display region 20B of the substrate 21 indicated by a broken line.

Hereinafter, the method of producing the organic EL display device shown in Fig. 2 will be described.

Referring to Fig. 2, an ITO film having a thickness of 150 nm is first formed uniformly on the polycarbonate substrate 21 above, and ITO scanning electrode patterns 22A having a width of 200 μm extending at an angle of 45 degrees with respect to the long side of the substrate 21 is formed thereon in parallel with each other at an interval of 10 μm by patterning in a photolithographic process. Although not show in the Figure, a lead for connection with the drive circuit 22B extending in the vertical direction toward the long side is formed at the terminal long side facing the drive circuit 22B of each ITO scanning electrode pattern 22A.

In addition, Al lead electrode patterns (not shown in the Figure) having a width of 200 μm for connection with the drive circuit 24B are formed at an interval of 10 μm on the other long side of the substrate 21, facing the drive circuit 24B.

Then, on the ITO scanning electrode pattern 22A thus formed, an α-NPD film constituting the hole-transporting layer 23a and an Alq3 film constituting the light-emitting layer 23b and the electron-transporting layer 23c both having a thickness of 50 nm are formed by vapor deposition respectively by using a vapor deposition mask; additionally, a LiF film having a thickness of 0.5 nm was formed on the electron-transporting layer 23c; and Al data electrode patterns 24A having a width of 200 μm and a thickness of 100 nm are formed thereon at an interval of 10 μm gap by using a vapor deposition mask. Each Al data electrode pattern 24A is connected to an Al lead electrode pattern previously formed on the substrate 21.

Finally, a polycarbonate sealing plate of 30 mm×70 mm×0.3 mm in size (not shown in the Figure) is placed on the substrate 21 covering the display region 20A under nitrogen atmosphere, and bonded with a UV-curable adhesive.

In this way produced is a passive display device having a display region 20A of 25.2 mm×67.2 mm in size and 3.3 inches in diagonal length at a density of 38420 (170×226) pixels in the display region 20A. The open area ratio of the display device is 90.7%, and the light-emitting layer 23b emits green light, when each pixel is turned on by using the ITO scanning electrode pattern 22A as anode and the Al data electrode pattern 24A as cathode.

Fig. 4 shows the results of measuring the relative brightness distribution in the lengthwise direction in the display region 20A of the organic EL display device 20 in the configuration shown in Fig. 2 thus formed.

As shown in Fig. 4, although there is slight change in brightness observed in the lengthwise direction of the display region 20A presumably due to the Al data electrode pattern 24A, there is completely no variation in brightness, a possible cause of voltage drop, in the crosswise direction in the organic EL display device 20, and the fluctuation in

brightness of the entire display region was found to be controlled in the range 8% or less.

In contrast in a device having a conventional configuration in which, on the polycarbonate substrate of 50×110×0.3 mm in size, an ITO electrode patterns 12A and Al electrode patterns 14A are formed similarly in the crosswise and lengthwise directions as shown in Fig. 1, there is substantial fluctuation in brightness observed in the long side direction (crosswise direction) of the screen on which the ITO electrode patterns 12A extend, i.e., increase in the emission intensity of organic EL element in the areas close to the drive circuits, as shown in Fig. 5. However in the experiment shown in Fig. 5, ITO electrode patterns 12A having a width of 200 μm respectively extending in the crosswise direction are formed repeatedly at an interval of 10 μm in the lengthwise direction as scanning electrodes 12; Al electrode patterns 14A having a width of 200 μm respectively extending in the lengthwise direction are formed repeatedly at an interval of 10 μm in the crosswise direction as the data electrodes 14; and the organic EL elements described in Fig. 3 are formed at the intersections of respective ITO electrode patterns 12A and Al electrode patterns 14A.

Thus according to the invention, it is possible to reduce the brightness distribution in a passive-matrix display device, by using the electrode configuration described in Fig. 2.

In addition, there is no restriction on the substrate size in the crosswise direction in the passive-matrix display device 20 shown in Fig. 2, and thus, as shown in Fig. 6, it is possible to expand the width of the substrate 21 and the display region 20A freely.

In the organic EL display device 20 in the configuration shown in Fig. 2, the intersections between the ITO scanning electrode patterns 22A and the Al data electrode patterns 24A, i.e., the regions where the organic EL elements 23 are formed to be pixels, are generally not arranged in the matrix shape but in a complicated arrangement pattern.

However, when the Al data electrode patterns 24A extending in parallel on the short side of the substrate 21 have a width x and an interval of x', and the ITO scanning electrode patterns 22A extending in parallel with the long side of the substrate 21 have a width y and an interval of y', if the angle θ (see Fig. 2) between the data electrode pattern 24A and the scanning electrode pattern 22A satisfies the following relationship:

$$\sin(90-\theta) = n(y+y')/m(x+x') \quad (1),$$

wherein each of n and m is 1, 2, or 3, the arrangement in the pixel region becomes ordered. Thus, the angle θ is preferably selected to satisfy the relationship (1) above, especially when the organic EL display device shown in Fig. 2 is used for display of image information.

In an organic EL display device 20 having the configuration shown in Fig. 2, if the length of the long side of display region 20A is designated as S and that of the short side as L, the angle θ1 (=90-θ) between the scanning electrode 22A and the long side is preferably selected to satisfy the following relationship:

$$L \geq S/\sin\theta 1.$$

[Second embodiment]

Fig. 7 is a view illustrating the configuration of the display device 40 in the second embodiment of the invention. In the Figure, the same reference numbers are allocated to the regions corresponding to those described above, and duplicated description is omitted.

As shown in Fig. 7, in the present Example the lead terminals of the ITO scanning electrode patterns 22A and the lead terminals of the Al data electrode patterns 24A are formed alternately on the same edge of a polycarbonate substrate 21, and a flexible polycarbonate substrate 25 carrying drive circuits 22B and 24B is formed adjacent to it. In addition, the substrates 21 and 25 are connected to each other, via TAB leads 25C, composite of the TAB leads 22C and 24C above.

Thus in the configuration shown in Fig. 7, the drive circuits are connected only to one side of the flexible substrate 21, leading to less reduction in flexibility due to the connection and allowing production of a display device having a seamless circular display screen such as that shown in Fig. 8.

[Third embodiment]

Fig. 9 is a view illustrating the configuration of the organic EL display device 60 in the third embodiment of the invention. In the Figure, the same reference numbers are allocated to the regions corresponding to those described above, and duplicated description is omitted.

As shown in Fig. 9, also in the present embodiment, the ITO scanning electrode patterns 22A constituting the scanning electrode are arranged at a slant with respect to the long and short sides of the substrate 21, and, as a result, there is an angle $\theta_3$ between the ITO scanning pattern 22A and the long side; but, in the present embodiment, the Al data electrode patterns 24A extending in parallel on the short side of the substrate 21 in the embodiment of Fig. 2 are also arranged at a slant with respect to the short side at the same angle $\theta_3$ as the ITO scanning electrode patterns 22A; and, as a result, an angle of $2\theta_3$ is formed between the ITO scanning electrode pattern 22A and the Al data electrode pattern 24A. In addition, a SiN film having a thickness of 1 $\mu$m is formed by sputtering as an insulation film in the region of the non-display region where no light is desirably emitted.

Fig. 10 is a view illustrating the display region shown in Fig. 9 in more detail.

As shown in Fig. 10, in the present Example, each of the ITO scanning electrode patterns 22A is a thin ITO pattern 22r, 22g, or 22b, and an organic EL element R emitting red light is formed on the ITO pattern 22r, an organic EL element G emitting green light on the ITO pattern 22g, and an organic EL element B emitting blue light on the ITO pattern 22b.

For example, the red organic EL element R is prepared by using a mixture of Alq3 described above and DCJTB represented by the following Formula added in an amount of 1 wt % as the light-emitting layer 23b. The material described in the first embodiment above can be used for the green organic EL element G

A material having a BCP layer containing a CBP layer of 20 nm in thickness containing tppy represented by the following Formula in an amount of 10 wt % formed as a light emitting layer 23b on the hole transporting layer 23a of $\alpha$-NPD having a thickness of 50 nm and additionally an electron-transporting layer 23c consisting of a BCP layer represented by the following Formula having a thickness of 10 nm and the Alq3 layer having a thickness of 50 nm can be used as the blue organic EL element B.

Such organic EL elements R, G, and B may be formed, for example, in a printing process or a vacuum deposition process.

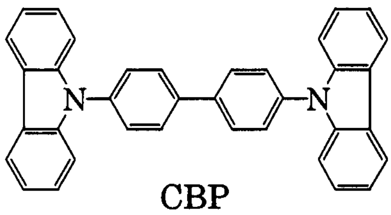
CBP

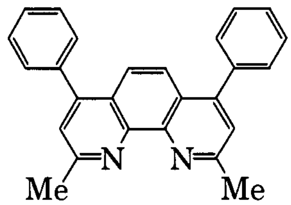
BCP

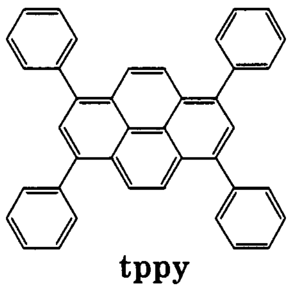
tppy

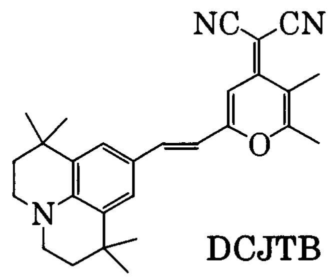
DCJTB

In the present embodiment, the ITO scanning electrode patterns 22A having a width of 60 $\mu$m are formed repeatedly at an interval of 10 $\mu$m. Also in the present embodiment, the display region has a dimension of 25.2 mm$\times$67.2 mm, and 38420 (170$\times$226) pixels are placed in the display region. Each pixel is a red organic EL element R, a green organic EL element G or a blue organic EL element B. The display device 60 thus obtained has an open area ratio of 81.6%.

In the organic EL display device 60 shown in Fig. 9, when all scanning electrodes (ITO patterns 22A) and all data electrodes (Al patterns 24A) were selected and driven, white EL emission was obtained.

Fig. 11 is a chart showing the relative brightness distribution of the white EL emission thus obtained in the organic EL display device 60 shown in Fig. 9 in the lengthwise direction (short-side direction).

As apparent from Fig. 11, although there is some change in brightness in the lengthwise direction due to the electric resistance of Al data electrode pattern 24A, there is completely no fluctuation in brightness in the crosswise direction presumably due to voltage drop in the display device, and the fluctuation in brightness in the entire display

region was controlled in the range of 10% or less.

In contrast, evaluation of the distribution of white luminescence brightness by the organic EL display device in a comparative example having ITO scanning electrode patterns 22A having the same width of 60 μm extending at an interval of 10 μm in the lengthwise direction (short-side direction of the substrate) and A1 data electrode patterns 24A having a width of 120 μm extending at an interval of 10 μm in the crosswise direction (long-side direction of substrate) as shown in Fig. 12 revealed a remarkable brightness distribution up to the maximum of 23% in the crosswise direction as shown in Fig. 13. However, the organic EL display device used in the experiment of Fig. 13 has a configuration similar to that of the organic EL display device 60 shown in Fig. 9 except its electrode arrangement and has 38400 (120×320) organic EL display elements in a display region of 25.2×67.2 mm in size and an open area ratio of 81.6%.

Thus according to the organic EL display device 60 in the present embodiment, it is possible to provide a display region with any aspect ratio with a uniform brightness distribution similarly to that in the organic EL display device 20 shown in Fig. 2.

As shown back in the electrode arrangement of Fig. 9, in the present embodiment, because ITO scanning electrode patterns 22A and Al data electrode patterns 24A have the same tilt angle θ3 with respect to the long side of substrate 21, pixels formed on the intersections of respective ITO scanning electrode patterns 22A and Al data electrode patterns 24A are arranged orderly both lengthwise and crosswise on the substrate 21.

On the other hand, as shown in Fig. 14, pixels formed on the intersections of the electrode patterns 22A and 24A intersected at a slant from each other have a rhombic shape when the angle θ3 is not 45 degrees, and in particular, the flatness of the rhombus, i.e., aspect ratio, increases when the angle θ3 deviates more from 45 degrees.

Fig. 15 shows the relationship between the angle θ3 and the pixel aspect ratio.

As shown in Fig. 15, when the angle θ3 is 20 or 70 degrees, the pixel aspect ratio becomes approximately 1: 3, and when the angle θ3 is greater or smaller than it, the pixel becomes very slender and undesirable for display. For that reason, it is concluded that the angle θ3 in the configuration shown in Fig. 9 is preferably set to an angle in the range of 20 degrees or more and 70 degrees or less ($20 \leq θ3 \leq 70$). In particular when the θ3 is 45 degrees, the ITO scanning electrodes 22A and Al data electrodes 24A cross each other at a right angle, and the pixels formed on the intersections become square or rectangular in shape.

In such an organic EL display device for color display, it is possible to display multiple desirable colors by using a monochrome element, for example white organic EL element, as the organic EL element, together with a color filter (s). In such a case, in the organic EL element shown in Fig. 3, the color filter (not shown in the Figure) is formed between the ITO electrode 22A and the substrate 21.

In such an organic EL display device for color display, it is also possible to display multiple desirable colors in the organic EL element, by using a monochromic blue organic EL element and a color-converting layer(s) in combination. In such a case, in the organic EL element shown in Fig. 3, the color-converting layer is preferably formed between the ITO electrode 22A and the substrate 21.

[Fourth embodiment]

Fig. 16 is view illustrating a method of driving the passive-matrix organic EL display device in the fourth embodiment of the invention.

As shown in Fig. 16, the passive-matrix organic EL display device shown in the Figure is the same as that in Fig. 2, but, in the present embodiment, a desirable display is performed by driving the multiple ITO scanning electrode patterns 22A indicated by stars simultaneously.

The distance between the ITO electrode patterns 22A simultaneously driven then is so adjusted that only one pixel on a single data electrode pattern 24A emits light. It is thus possible to display an image in a drive mode similar to that for the conventional display device 10 having the ITO scanning electrode patterns 12A shown in Fig. 1 extending in the crosswise direction of substrate.

In Fig. 16, decrease in the angle θ of ITO electrode patterns 22A leads to increase in the number of the ITO electrode patterns 22A driven simultaneously, and vice versa. A display device of which the angle θ is zero corresponds to the conventional display device 10 shown in Fig. 1, and in such a case, the number of the ITO scanning electrode patterns 12A driven simultaneously is one. Of course, the invention does not include such a conventional display device.

In the description above, the invention was described as a passive-matrix organic EL display device, but the invention is not limited to display devices using such a particular light-emitting element, and is applicable to other light emitting devices having a passive matrix configuration such as light emitting devices using an LED array. The passive-matrix light emitting devices according to the invention also include liquid crystal display devices having a backlight, and others.

In addition, the passive-matrix organic EL display device according to the invention becomes a surface light source, when all scanning electrode patterns 22A and all data electrode patterns 24A are selected and turned on. It is also possible to control the illumination brightness of such a surface light source by adjusting the numbers of the selected

scanning electrode patterns 22A and data electrode patterns 24A.

Favorable embodiments of the invention were so far described above, but the invention is not limited to the embodiments above, and various modifications are possible in the scope described in Claims.

INDUSTRIAL APPLICABILITY

According to the invention, because the drive electrodes form a certain angle, that is neither parallel nor perpendicular to a given side of the display region, each scanning line in the multiple drive electrodes needs not to extend continuously from one end to the other in the long side direction of the display region even if the substrate is wider in width, thus reducing the voltage drop in the scanning line and preventing deterioration in light intensity of the light-emitting element. The invention thus gives a passive-matrix light emitting device having any aspect ratio. The display device can be used not only as an information display device but also as a surface-emission light source.

## Claims

1. A light emitting device, comprising a substrate, and multiple drive electrodes formed on the substrate and used to obtain desired light emission, the multiple drive electrodes forming a passive-matrix-driven electrode arrangement, wherein
at least one drive electrode in a display region of the substrate forms an angle, that is neither parallel nor perpendicular to a given side of the display region.

2. The light emitting device of Claim 1, wherein the multiple drive electrodes form striped electrodes on the substrate and the striped electrodes are taken out from one side of the display region.

3. The light emitting device of Claim 1, wherein the multiple drive electrodes form striped electrodes on the substrate and the striped electrodes are taken out from two opposing sides of the display region.

4. The light emitting device of Claim 1, wherein an organic EL element is used as a light-emitting element for the light emitting device.

5. The light emitting device of Claim 1, which is capable of multicolor display by using multiple organic EL elements emitting lights different in color as light-emitting elements for the light emitting device.

6. The light emitting device of Claim 1, which is capable of multicolor display by using a monochrome organic EL element as a light-emitting element for the light emitting device together with a color filter.

7. The light emitting device of Claim 1, which is capable of multicolor display by using at least one monochrome organic EL element as a light-emitting element for the light emitting device together with a color-converting layer.

8. The light emitting device of Claim 1, wherein at least the display region of the substrate used in the light emitting device is flexible.

9. The light emitting device of Claim 1, having a cylindrical light emitting region.

10. The light emitting device of Claim 1, wherein, when the length of a long side of two sides of the display region is designated as L, that of a short side, S, and the angle of the drive electrode that is neither parallel nor perpendicular to a given side of the display region with respect to the long side is $\theta 1$ ($0 < \theta 1 < 90$), the following Formula (1) is satisfied:

$$L \geq S/\sin\theta 1 \qquad \text{[Formula (1)]}.$$

11. The light emitting device of Claim 1, wherein: the multiple drive electrodes include first and second drive electrodes; the second drive electrodes are perpendicular to the long side of the display region; the second drive electrodes are placed at an angle that is neither parallel or perpendicular to a given side of the display region; and, when the width of the first electrode is designated as x, the distance between the first electrodes x', the width of the second electrode y, the distance between the second electrodes y', and the angle of the first and second electrodes crossing

each other θ2 (0 < θ2 < 90), the following Formula (2) is satisfied:

$$\sin(90-\theta 2) = n(y+y')/m(x+x') \qquad \text{[Formula (2)]}$$

wherein each of m and n is an integer of 1, 2, or 3.

**12.** The light emitting device of Claim 1, wherein the multiple drive electrodes include scanning electrodes and data electrodes, and the scanning electrodes and the data electrodes have almost the same angle θ3 (0 < θ3 < 90) with respect to a given side of the display region.

**13.** The light emitting device of Claim 12, wherein the value of θ3 satisfies the following Formula:

$$20° \leq \theta 3 \leq 70°.$$

**14.** The light emitting device of Claim 12, wherein the scanning electrodes and the data electrodes cross each other substantially at a right angle.

**15.** The light emitting device of Claim 1, wherein light emitting elements arranged on two or more scanning electrodes are capable of emitting light simultaneously at a desired brightness, during duty driving using drive electrodes placed as scanning and data electrodes in the display region.

**16.** An illumination device comprising a substrate and multiple drive electrodes formed on the substrate and used to obtain desired light emission, the multiple drive electrodes forming a passive-matrix-driven electrode arrangement, wherein
at least one drive electrode in the display region of the substrate has an angle that is neither parallel nor perpendicular to a given side of the display region.

FIG.1

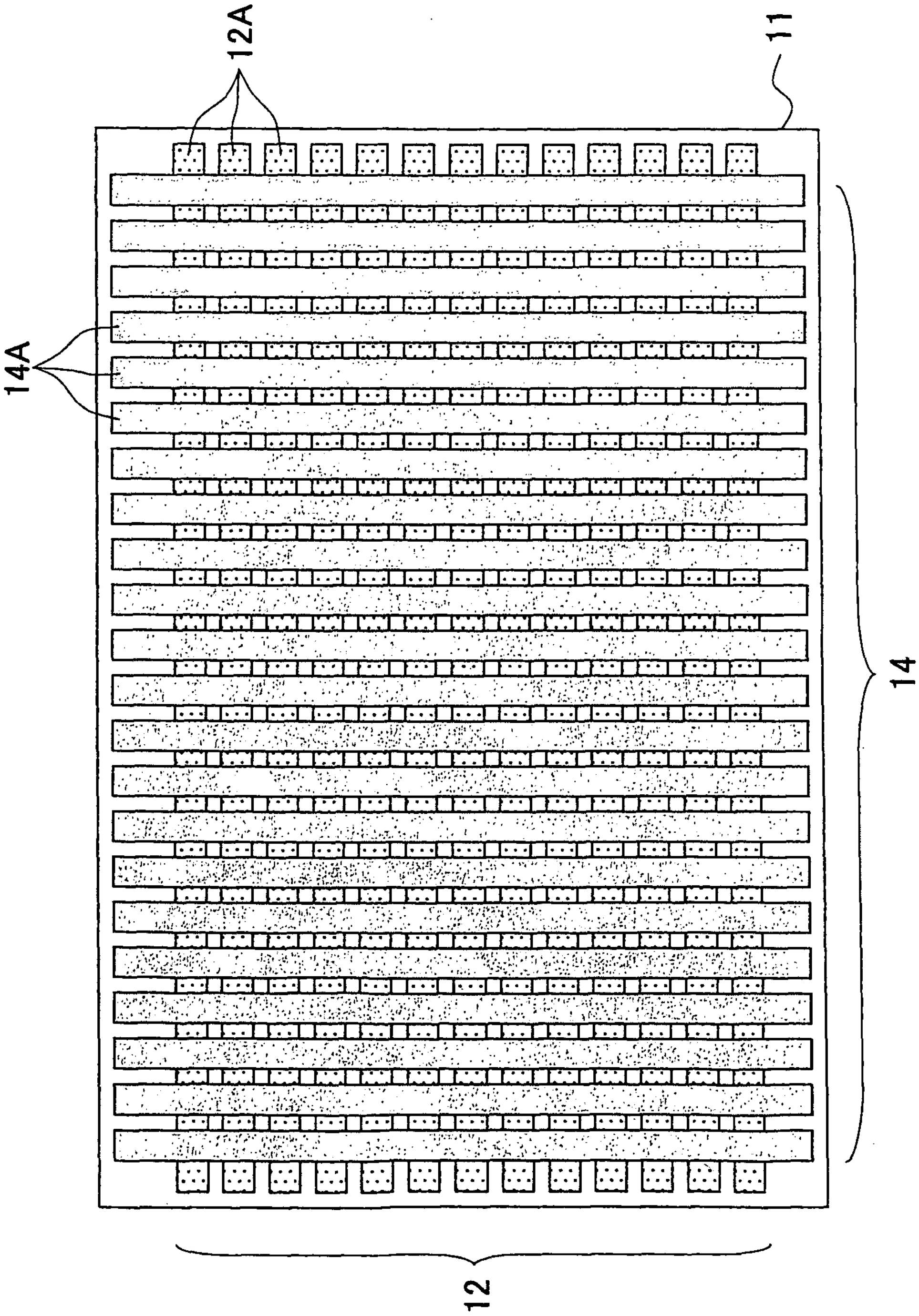

FIG.2

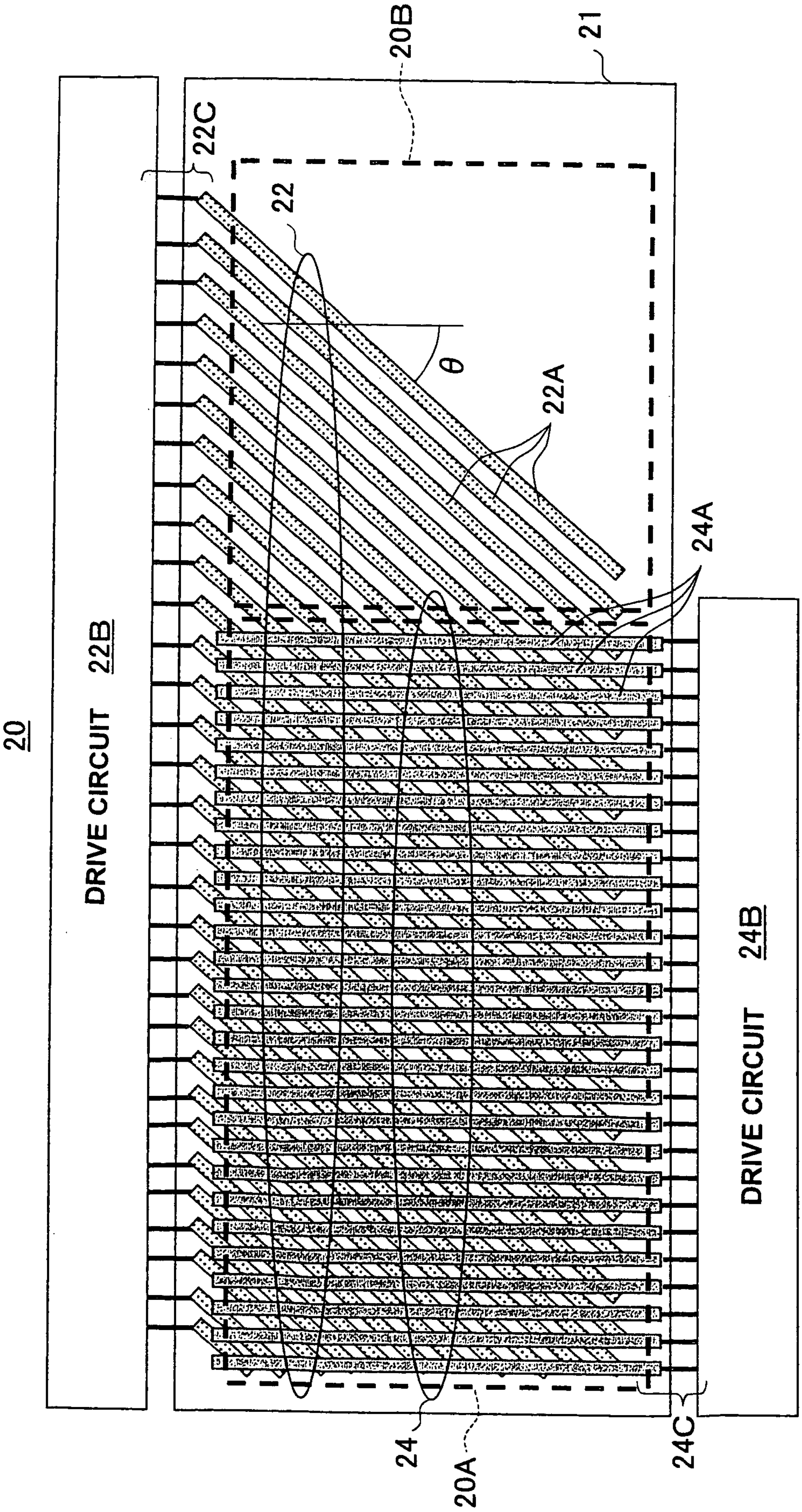
20
DRIVE CIRCUIT 22B
DRIVE CIRCUIT 24B
20B
21
22C
22
θ
22A
24A
24
20A
24C

FIG.3

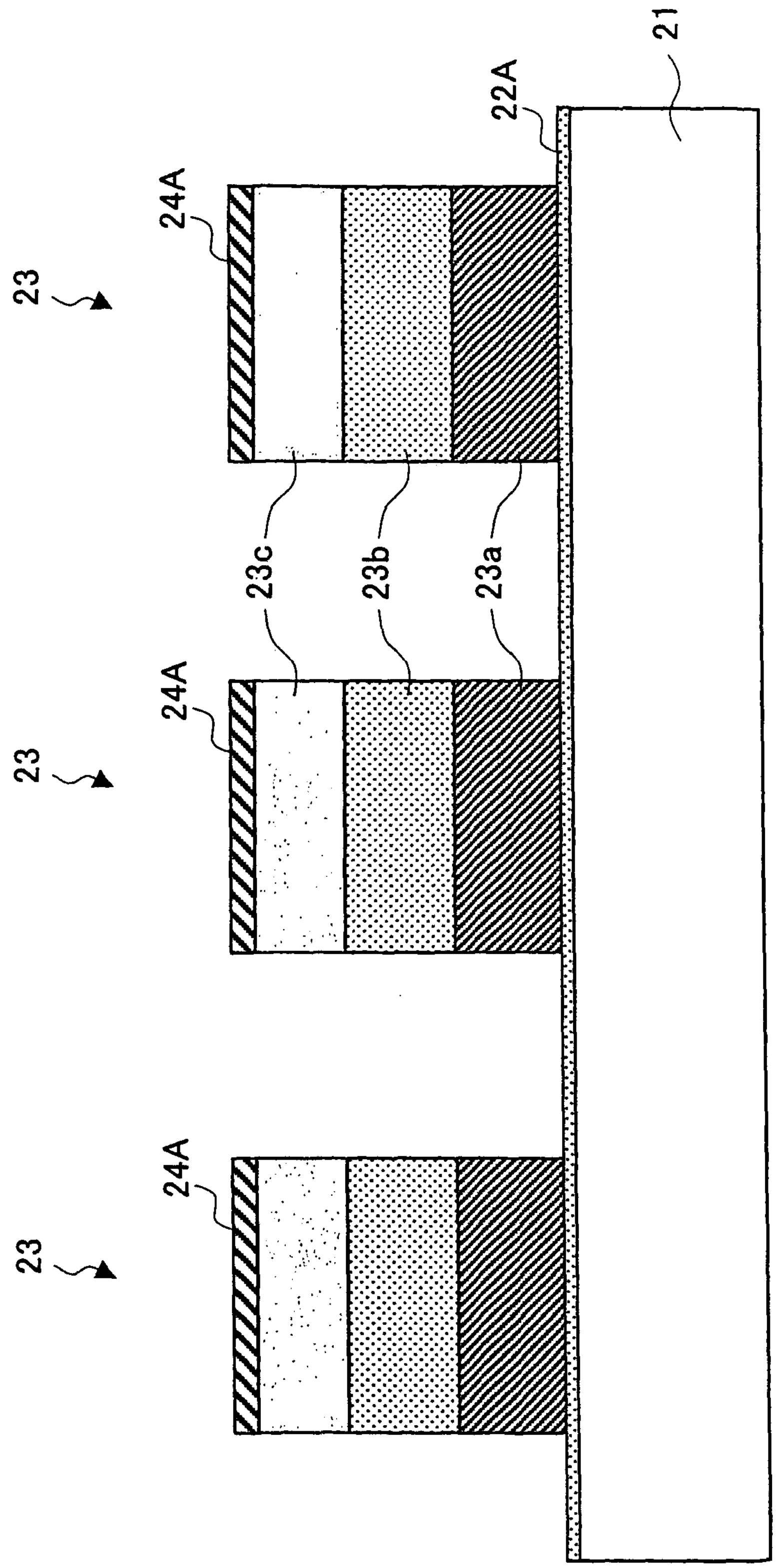

FIG.4

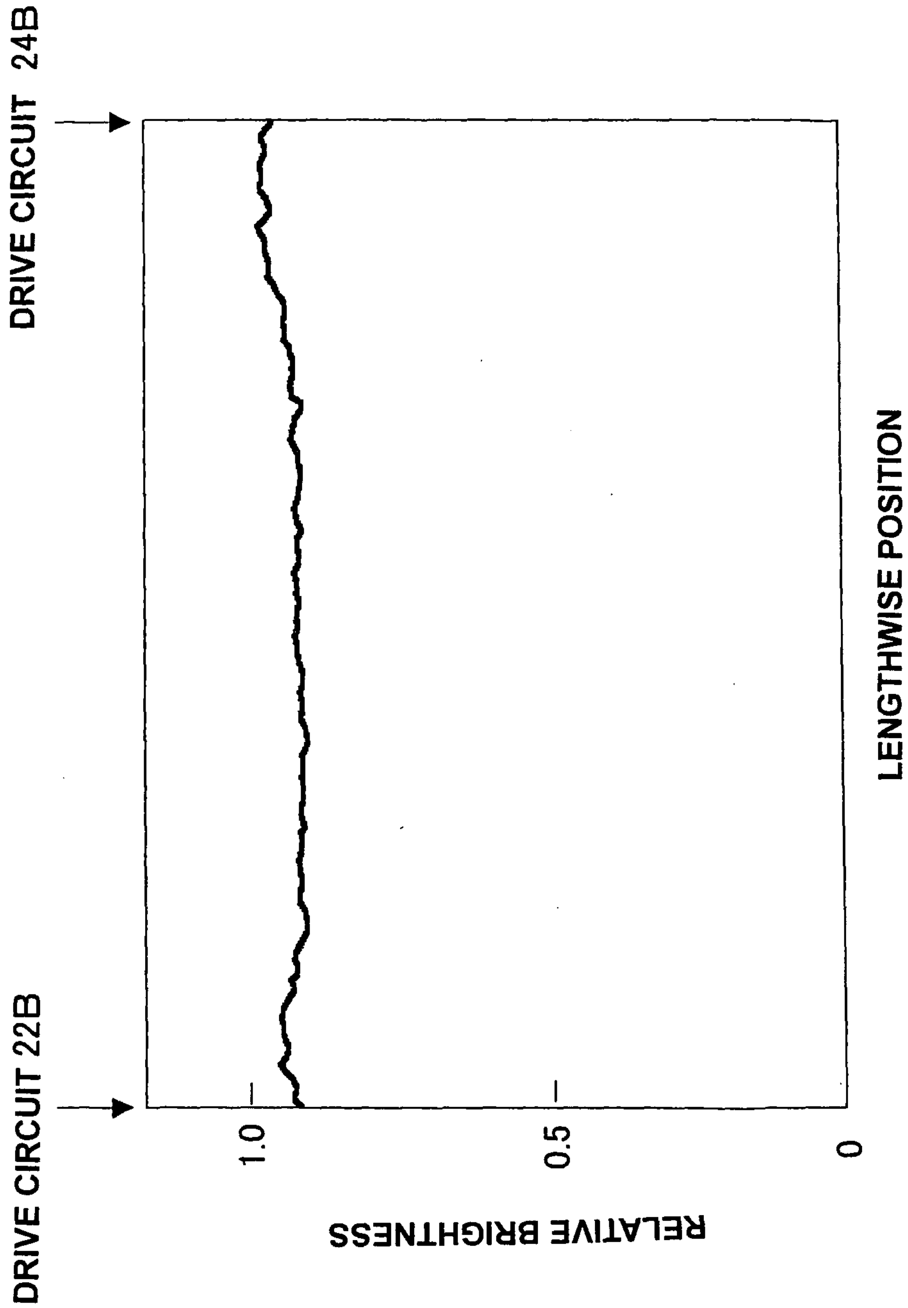
DRIVE CIRCUIT 24B
DRIVE CIRCUIT 22B
1.0
0.5
0
RELATIVE BRIGHTNESS
LENGTHWISE POSITION

FIG.5

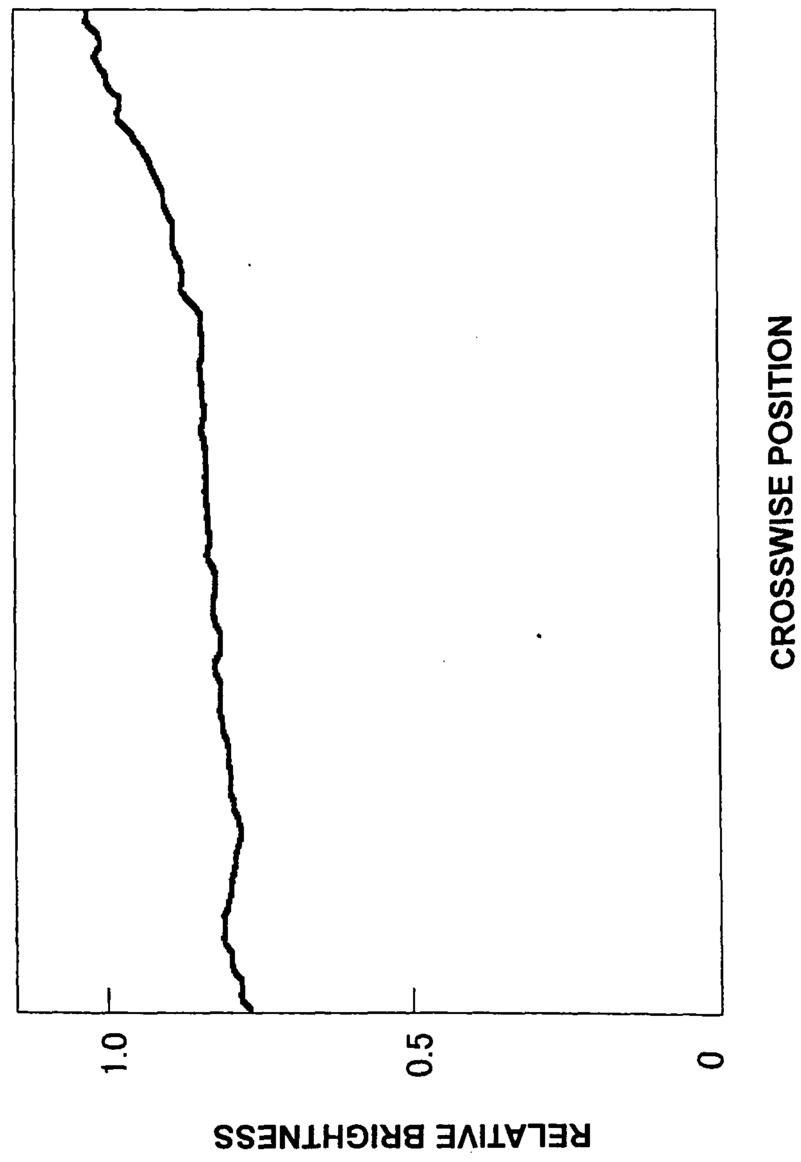

FIG.6

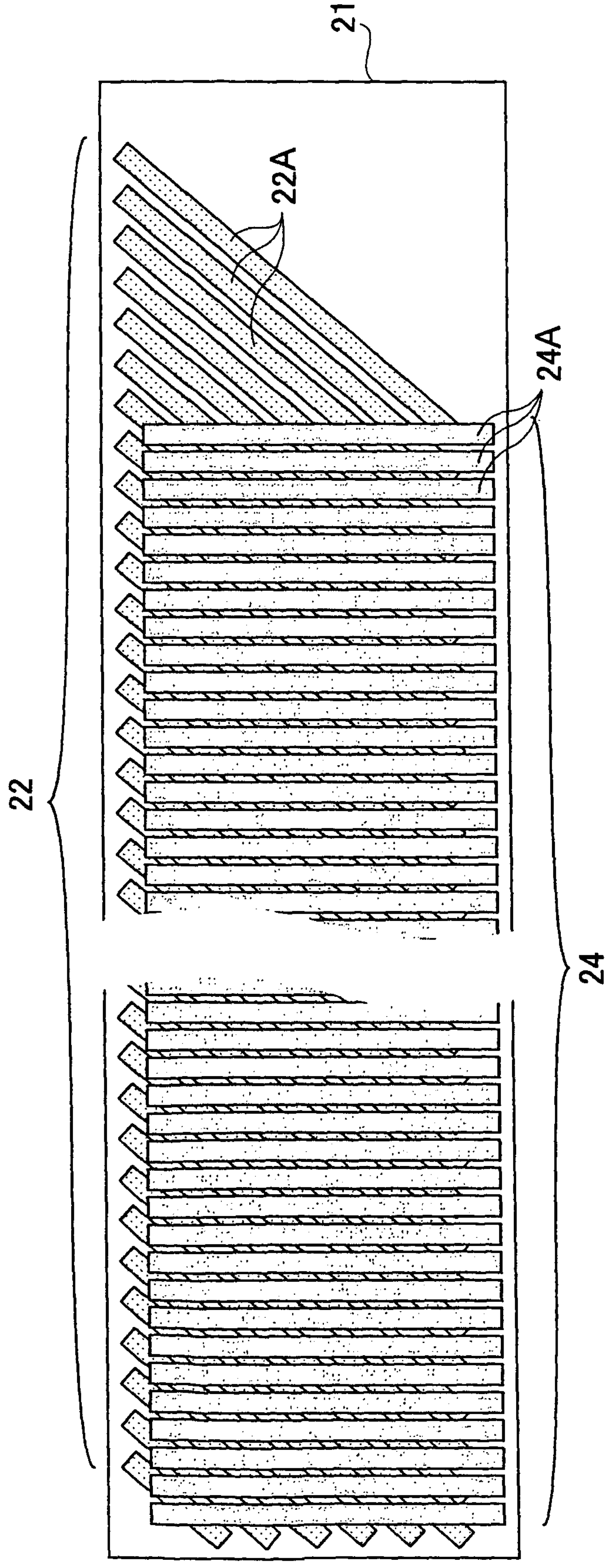

FIG.7

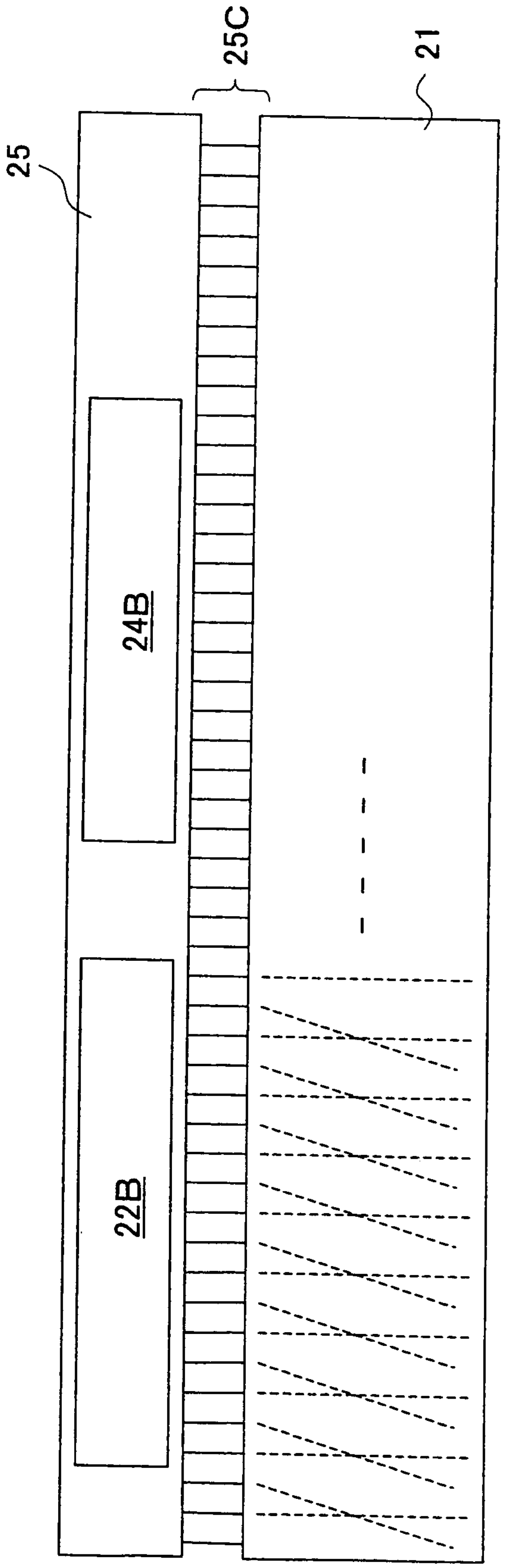

FIG.8

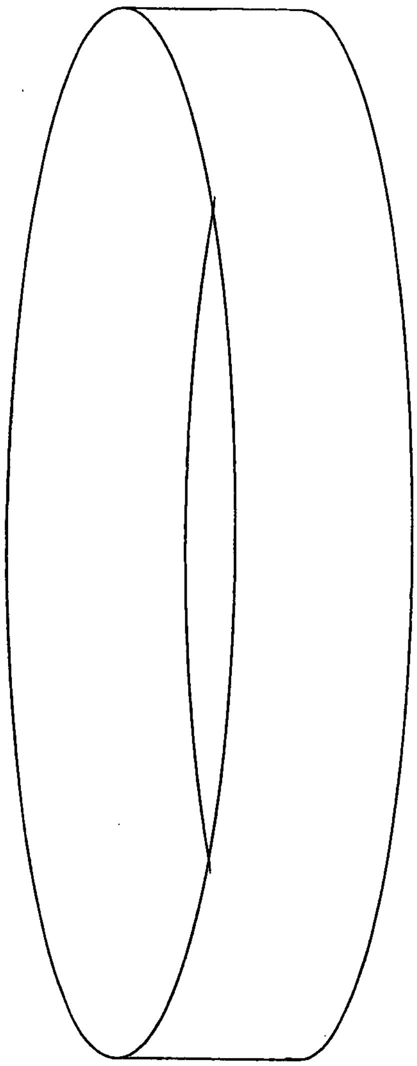

FIG.9

60

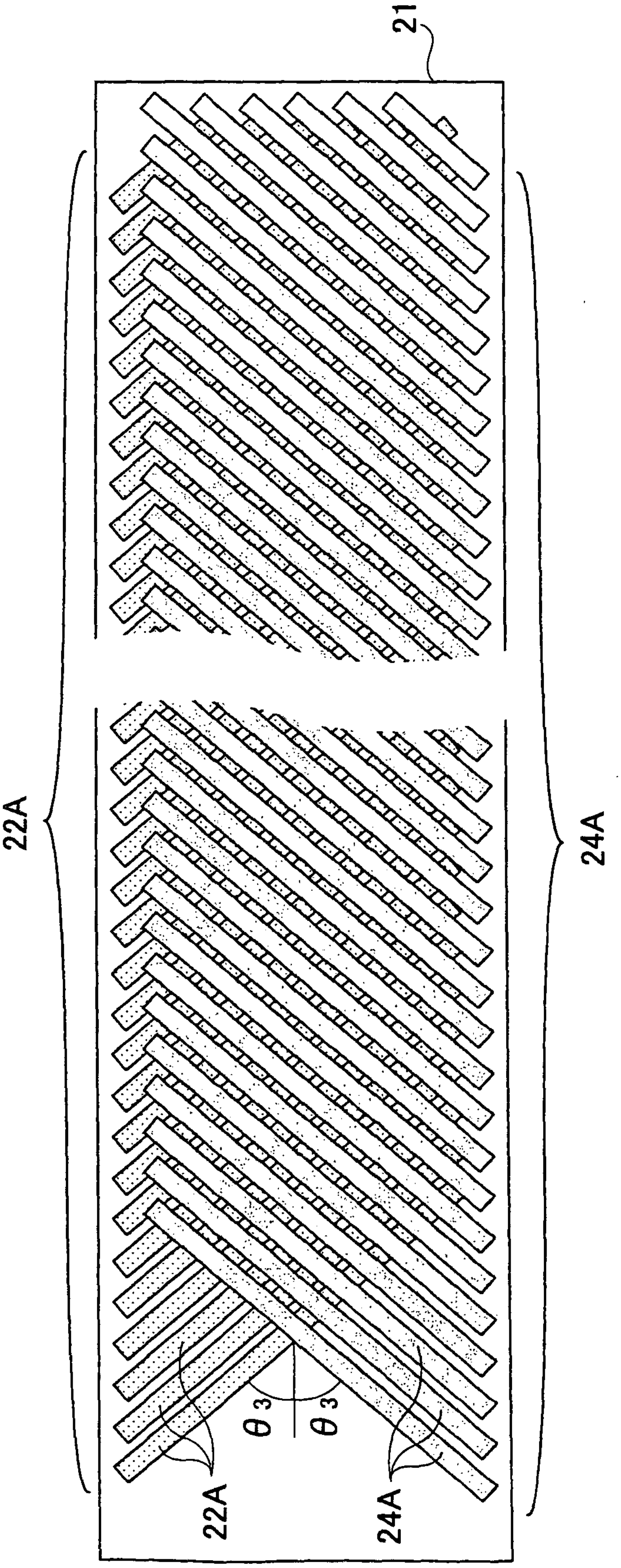

FIG.10

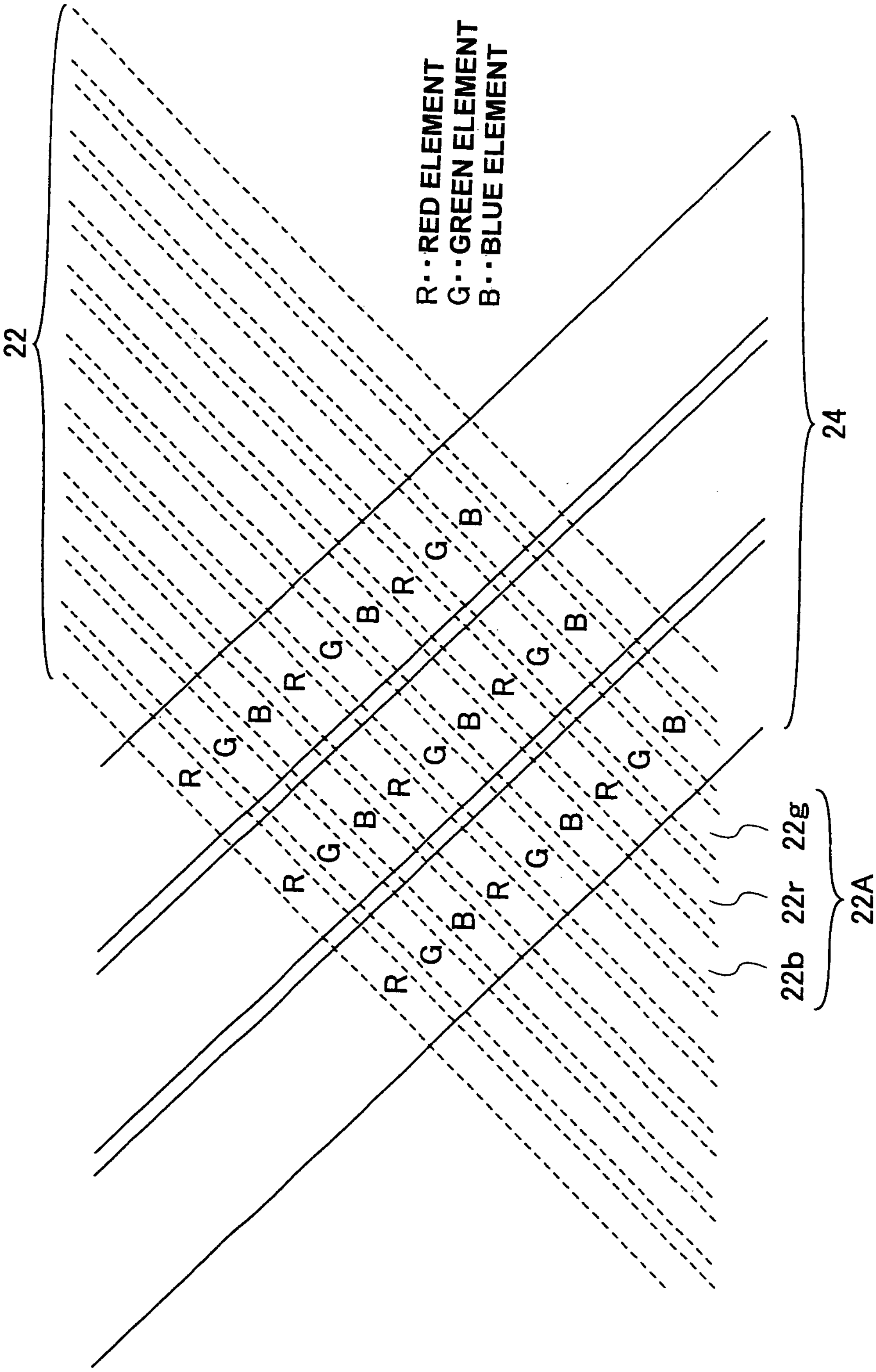

22
R··RED ELEMENT
G··GREEN ELEMENT
B··BLUE ELEMENT
24
22g
22r
22b
22A

FIG.11

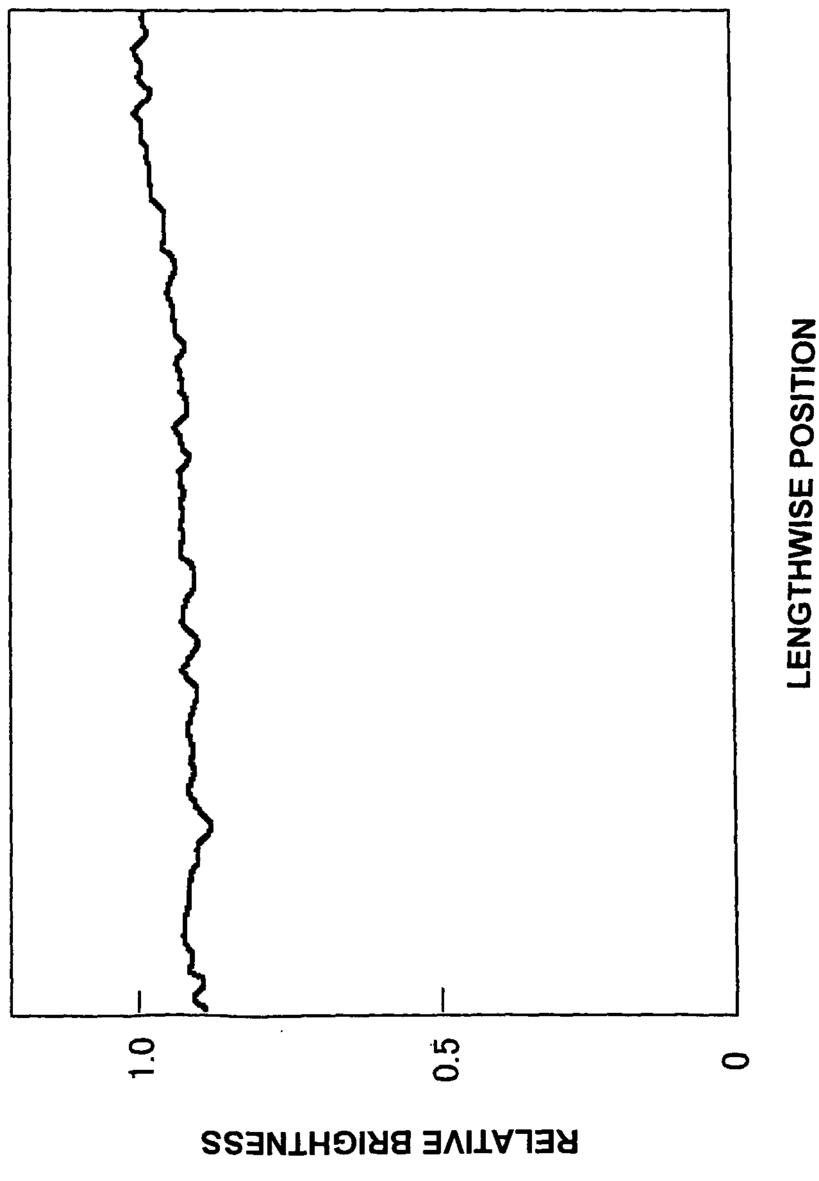

FIG.12

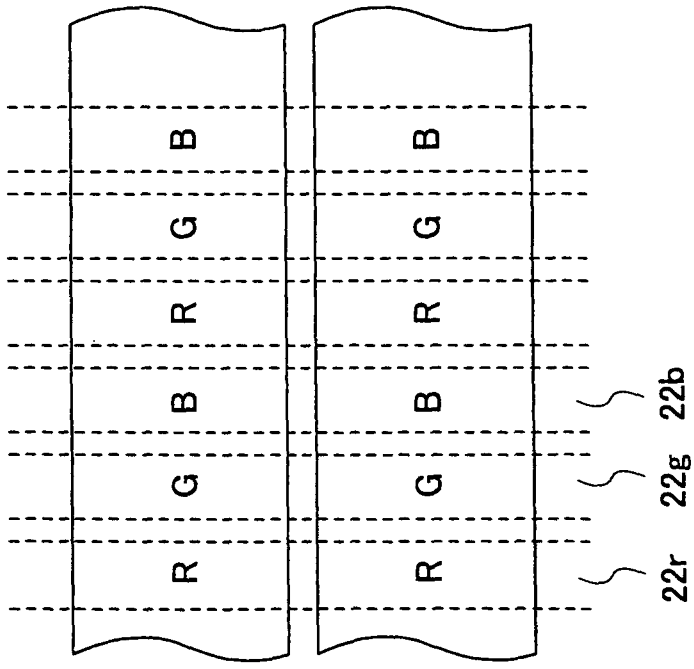


R‥RED ELEMENT
G‥GREEN ELEMENT
B‥BLUE ELEMENT

FIG.13

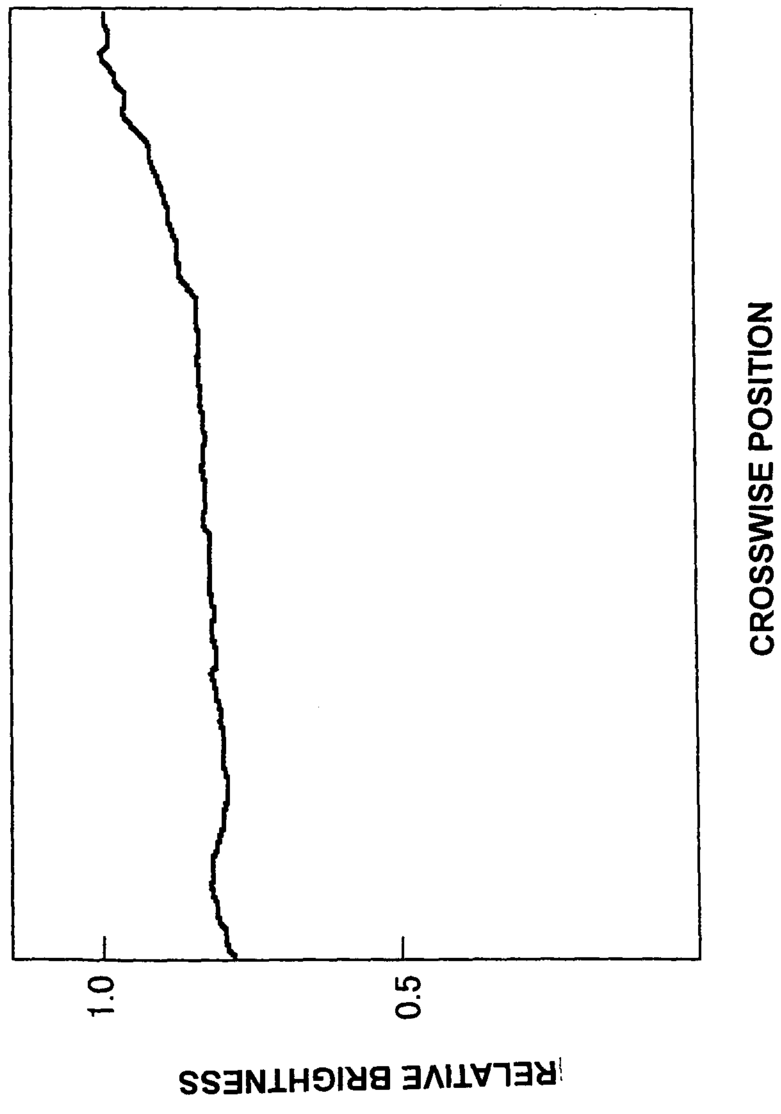

FIG.14

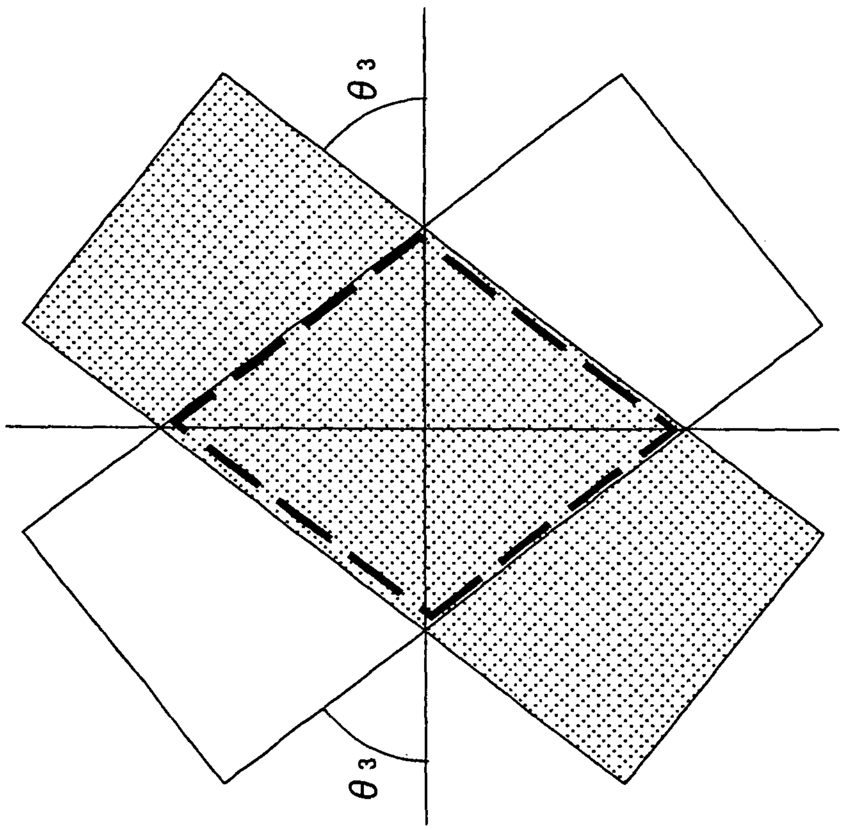

FIG.15

| $\theta_3$ | 10 | 15 | 20 | 25 | 30 | 35 | 40 | 45 | 50 | 55 | 60 | 65 | 70 | 75 | 80 |
|---|---|---|---|---|---|---|---|---|---|---|---|---|---|---|---|
| PIXEL (LENGTHWISE) | 0.17 | 0.26 | 0.34 | 0.42 | 0.50 | 0.57 | 0.64 | 0.71 | 0.77 | 0.82 | 0.87 | 0.91 | 0.94 | 0.97 | 0.98 |
| PIXEL (CROSSWISE) | 0.98 | 0.97 | 0.94 | 0.91 | 0.87 | 0.82 | 0.77 | 0.71 | 0.64 | 0.57 | 0.50 | 0.42 | 0.34 | 0.26 | 0.17 |
| ASPECT RATIO | 0.18 | 0.27 | 0.36 | 0.47 | 0.58 | 0.70 | 0.84 | 1.00 | 0.84 | 0.70 | 0.58 | 0.47 | 0.36 | 0.27 | 0.18 |

FIG.16

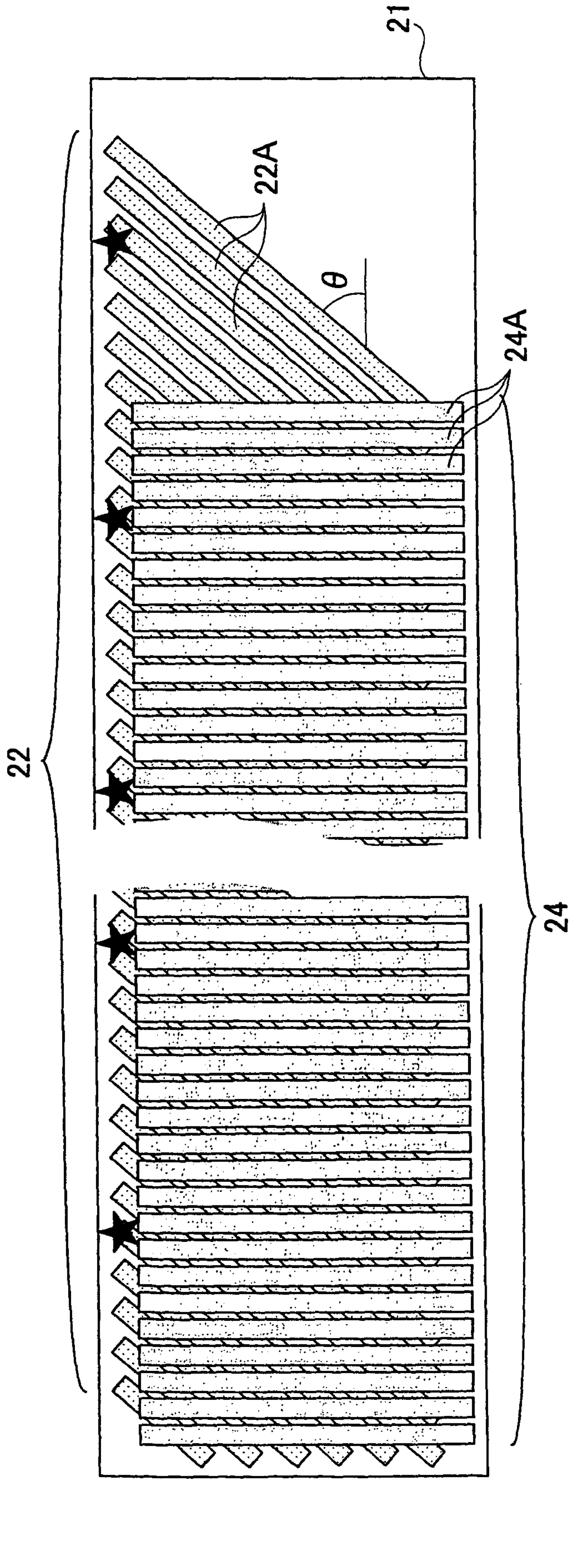

**INTERNATIONAL SEARCH REPORT**

International application No.
PCT/JP2004/004579

A. CLASSIFICATION OF SUBJECT MATTER
Int.Cl$^7$ H05B33/14

According to International Patent Classification (IPC) or to both national classification and IPC

B. FIELDS SEARCHED

Minimum documentation searched (classification system followed by classification symbols)
Int.Cl$^7$ H05B33/00-28, G09F9/00, G02F1/1335

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y | JP 2000-133151 A (Mitsubishi Electric Corp.), 12 May, 2000 (12.05.00), Claims 1 to 2; Par. Nos. [0011], [0018] to [0019], [0031] (Family: none) | 1,3-7,10-14, 16<br>8-9,15 |
| X | JP 08-334770 A (Victor Company Of Japan, Ltd.), 17 December, 1996 (17.12.96), Full text; all drawings (Family: none) | 1,16 |
| X<br><br>Y | JP 2000-228283 A (Kawaguchiko Seimitsu Co., Ltd.), 15 August, 2000 (15.08.00), Column 4, lines 31 to 35; Par. No. [0019]; Figs. 4, 6 (Family: none) | 1,4-7,10-11, 16<br>2-3,8-9,15 |

[X] Further documents are listed in the continuation of Box C. [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 July, 2004 (29.07.04) | 17 August, 2004 (17.08.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

International application No.
PCT/JP2004/004579

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-43952 A (LG Electronics Inc.), 14 February, 2003 (14.02.03), Full text; all drawings & EP 1260958 A & US 20020180670 A | 15 |
| Y | JP 2003-295785 A (Optrex Corp.), 15 October, 2003 (15.10.03), Full text; all drawings (Family: none) | 2,3 |
| Y | JP 2001-13898 A (Hokuriku Electric Industry Co., Ltd.), 19 January, 2001 (19.01.01), Par. No. [0026] (Family: none) | 8,9 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 3214593 A
- JP 7220871 A
- JP 3152897 A